# EUROPÄISCHE PATENTSCHRIFT

(11) **EP 1 131 848 B1**
(45) Veröffentlichungstag und Bekanntmachung des Hinweises auf die Patenterteilung: **11.06.2003**
(21) Anmeldenummer: 99968325.3
(22) Anmeldetag: 15.10.1999
(51) Int. Cl.: H01L 21/322, H01L 21/324, H01L 29/10, H01L 29/745, H01L 29/739, H01L 29/749

(54) **VERFAHREN ZUR HERSTELLUNG EINES LEISTUNGSHALBLEITERS MIT EINER STOPPZONE**
METHOD FOR PRODUCING A POWER SEMICONDUCTOR DEVICE WITH A STOP ZONE
PROCEDE DE PRODUCTION D'UN SEMICONDUCTEUR COMPORTANT UNE ZONE D'ARRET

(30) Priorität: 23.10.1998 DE 19848985
(43) Veröffentlichungstag der Anmeldung: 12.09.2001
(73) Patentinhaber: EUPEC Europäische Gesellschaft für Leistungshalbleiter mbH & Co. KG, 59581 Warstein-Belecke (DE)
(72) Erfinder: SCHULZE, Hans-Joachim, D-85521 Ottobrunn (DE); BARTHELMESS, Reiner, D-97483 Eltmann (DE)
(74) Vertreter: Viering, Jentschura & Partner
(86) Internationale Anmeldenummer: EP9907851
(87) Internationale Veröffentlichungsnummer: WO00025356

(56) Entgegenhaltungen:
- EP-A- 0 621 640
- DE-A- 3 937 393
- DE-A- 4 108 394
- DE-A- 4 223 914
- DE-A- 4 336 663
- DE-C- 4 013 626

## Beschreibung

Die vorliegende Erfindung betrifft ein Verfahren nach dem Oberbegriff von Anspruch 1. Die Erfindung befaßt sich demnach mit der Herstellung von Leistungshalbleitern.

Leistungshalbleiter müssen in der Lage sein, einerseits große Ströme zu transportieren und andererseits hohe Spannungen zu sperren, falls gewünscht.

Ein Problem kann dabei an den Übergängen zwischen unterschiedlich dotierten Bereichen des Leistungshalbleiters auftreten. Hier bildet sich beim Sperren eine Raumladungszone. Es muß vermieden werden, daß die Feldstärke in der Raumladungszone so hoch wird, daß es zu unerwünschten und im Extremfall bis zur Zerstörung des Leistungselementes führenden Durchbrüchen kommt. Ein erster Ansatz, um dies zu vermeiden, ist, den Leistungshalbleiter sehr dick auszubilden. Dies hat den Nachteil, daß über die Bauelementdicke im Leitungsfall ein unerwünscht großer Spannungsabfall mit entsprechend hohen Verlusten auftritt. Eine weitere Möglichkeit besteht darin, eine sog. Stoppzone zu schaffen, mit welcher die Ausdehnung der Raumladungszone begrenzt wird, indem eine Zone mit erhöhter Ladungsträgerdichte vorgesehen wird.

Unter Verwendung von Stoppzonen ist es möglich, die Dicke einseitig sperrender Bauelemente deutlich zu verringern, ohne die Sperrfähigkeit zu beeinträchtigen. Auf diese Weise werden die Verluste über den Halbleiter insbesondere bei hochsperrenden Bauelementen für Spannungen über 3 kV und mit Bauelementdicken oberhalb von 500 Mikrometern verringert.

Bislang wurden Stoppzonen durch gezielte Phosphordotierung gebildet. Hierzu wurde Phosphor zunächst in einen Bereich nahe der Halbleiteroberfläche durch Ionenimplantation eingebracht und dann mit einem nachfolgenden Eintreibeschritt in das Siliziumgrundmaterial des Leistungshalbleiters eindiffundiert. Die niedrige Diffusionsgeschwindigkeit von Phosphor in Silizium erfordert jedoch zur Erzeugung von Stoppzonen Temperaturen, welche oberhalb von 1200°C liegen und Diffusionszeiten von über zwanzig Stunden. Damit ist einerseits ein hoher Zeit- und Energieaufwand verbunden und andererseits eine hohe Belastung der Halbleiterbauelemente während der Fertigung.

Es ist auch bekannt, die elektronischen Eigenschaften eines Halbleiters wie durch eine Grunddotierung seines Si-Substrates nur durch thermische Behandlung eines fertigen Bauelementes zu verändern. Dabei soll der während des Herstellungsprozesses in alle Bereiche des Substrates gelangte Sauerstoff thermische Donatoren bilden. Verwiesen wird hierzu auf die DE 39 37 393 C2, DE 40 13 626 C1, DE 43 36 663 A1 sowie EP 621 640 A1.

Die Aufgabe der vorliegenden Erfindung besteht darin, Neues für die gewerbliche Anwendung bereitzustellen.

Die Lösung dieser Aufgabe wird unabhängig beansprucht. Bevorzugte Ausführungsform der Erfindung sind in den abhängigen Ansprüchen angegeben.

Ein Grundgedanke der vorliegenden Erfindung besteht also in der Erkenntnis, daß es möglich ist, eine räumlich eng begrenzte Stoppzone unter Verwendung von Sauerstoff zu bilden. Es wurde erkannt, daß der per se im unbehandelten Halbleitersubstrat wirkungslose Sauerstoff ohne weiteres an eine gewünschte Stelle im Substrat eingetrieben und erst danach durch Erwärmung des Halbleiters mit dem Sauerstoff ein thermischer Donator gebildet werden kann, und zwar ohne die Halbleitereigenschaften durch während der Bauelement-Herstellung ungezielt eingewanderten Sauerstoff grundlegend an allen Stellen zu verändern. Dies erlaubt die gezielte Bildung einer Stoppzone in einem genau definierten Bereich.

Der Sauerstoff kann zunächst oberflächennah angereichert werden, etwa durch Oxidation der Halbleiteroberfläche und/oder durch Ionenimplantation, so daß sich eine erhöhte Sauerstoffkonzentration nahe der Oberfläche im Vergleich zu anderen Halbleiterbereichen ergibt. Der somit vorhandene Sauerstoffgradient kann dann in einem weiteren Schritt ausgenutzt werden, um den Sauerstoff von dem oder einem Ort nahe der Oberfläche bis zur gewünschten Tiefe der Stoppzone zu diffundieren.

Das Substrat wird während des Diffusionsschrittes vorzugsweise auf eine Temperatur erwärmt, die eine vergleichsweise schnelle Eindiffusion des Sauerstoffes zur Folge hat, aber noch unterhalb der das Material stark belastenden Temperaturen liegt, wie sie im Stand der Technik nötig sind. Zugleich kann die Temperatur so hoch gewählt werden, daß der Sauerstoff nicht schon vor Erreichen der gewünschten Stoppzonentiefe in thermische Donatoren umgewandelt wird. Dies ist deshalb vorteilhaft, weil die Bildung thermischer Donatoren in Silizium mit Sauerstoff noch nicht in allen Einzelheiten und vollständig verstanden ist; es wird vermutet, daß sich die thermischen Donatoren durch Bildung eines Silizium-Sauerstoff-Komplexes ergeben. Durch hinreichend hohe Temperaturen wird aber verhindert, daß die Diffusionsgeschwindigkeit durch eine derartige Komplexbildung spürbar reduziert wird. Bevorzugt liegt die Temperatur beim Eindiffundieren daher auch oberhalb von etwa 520°C, da es möglich ist, die Bildung thermischer Donatoren durch Erwärmen auf eine hinreichend hohe Temperatur rückgängig zu machen, so daß davon ausgegangen werden kann, daß bei Temperaturen oberhalb von etwa 520°C, insbesondere über 550°C auch die Diffusion nicht mehr durch die Bildung thermischer Donatoren-Komplexe beeinträchtigt wird.

Das Substrat mit dem bis zur gewünschten Tiefe der Stoppzone eindiffundierten Sauerstoff wird dann auf eine Temperatur erwärmt, die zur Bildung thermischer Donatoren ausreicht, und auf einer solchen Temperatur bzw. in einem solchen Temperaturbereich gehalten, bis mit einem merklichen Teil des Sauerstoffes thermische Donatoren gebildet sind. Eine ausreichende Temperatur liegt zwischen 400°C und 500°C, insbesondere zwischen 420°C und 500°C, insbesondere bevorzugt bei 450°C. Die Zeit, während der sich eine merkliche Umsetzung des Sauerstoffes zu thermischen Donatoren ereignet, liegt typisch bei 15 Minuten bis 10 Stunden, wobei sich in der Praxis Zeiten zwischen 30 Minuten und 4 Stunden schon als ausreichend erwiesen haben.

Der Sauerstoff wird bevorzugt durch einen Bereich in das Substrat getrieben, welcher p-dotiert ist. Bei der Diffusion verbleibt naturgemäß ein Teil des an die Oberfläche eingetriebenen Sauerstoffes in dem p-dotierten Bereich, während der die Stoppzone eigentlich bildende Sauerstoff über den p-dotierten Bereich, bei dem es sich um einen Emitter handeln kann, hinausdiffundiert, um die eigentliche Stoppzone im Anschluß an den p-dotierten Bereich zu bilden. Somit werden bei der thermischen Umwandlung im p-dotierten Bereich gleichfalls wie in der Stoppzone thermische n-Donatoren erzeugt. Der p-dotierte Bereich wird so hoch p-dotiert, daß der Einfluß dieser thermisch erzeugten-Donatoren kompensiert ist.

In typischen Leistungshalbleitern wird es erforderlich sein, die Stoppzone bis in eine Tiefe von 20-40 Mikrometern einzudiffundieren. Angesichts des Diffusionsverhaltens von Sauerstoff in Silizium ist es ohne weiteres möglich, den bei diesen Tiefen im p-dotierten Bereich verbleibenden Sauerstoff und die damit gebildeten thermischen n-Donatoren ohne Erweiterung durch Erhöhung der p-Dotierung kompensieren, ohne daß negative Einflüsse befürchtet würden müssen.

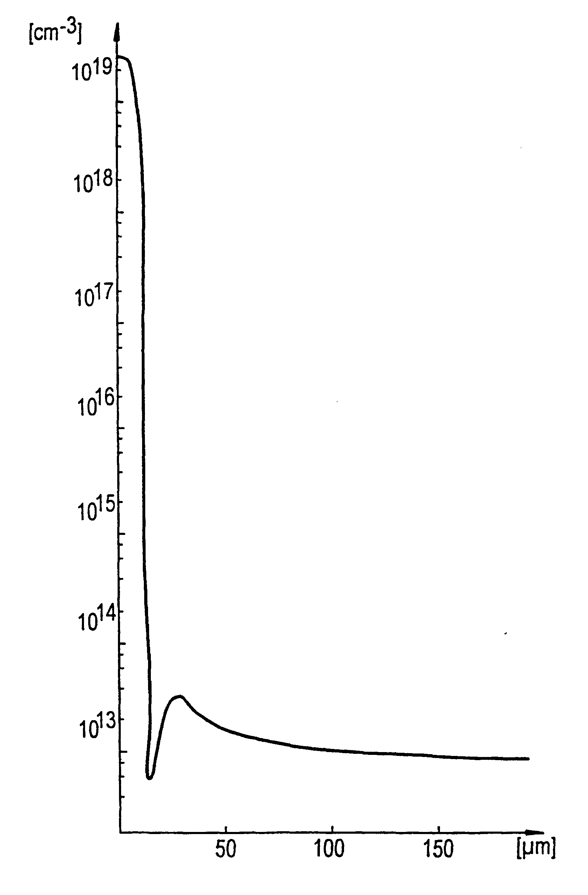

Die Erfindung wird im folgenden nur beispielsweise unter Bezugnahme auf die Zeichnung erläutert. In dieser zeigt
- Figur 1: die Ladungsträgerkonzentration eines nach dem Verfahren der vorliegenden Erfindung hergestellten GTOs mit kurzgeschlossener Anode über die Dicke des Halbleiters.

Es wird zunächst ein Leistungshalbleiter mit den üblichen Dotierungsstrukturen wie n- und p-Bereiche, Randabschlüssen, usw. erzeugt.

Dann wird gezielt in die oberflächennahen Bereiche eines p-dotierten Halbleiterbereiches, beispielsweise eines p-Emitters durch Ionenimplantation eine vorbestimmte Sauerstoffmenge eingebracht. Erforderlichenfalls werden hierzu gegebenenfalls umgebende Bereiche, in welche kein Sauerstoff implantiert werden soll, in bekannter Weise maskiert. Geeignete Masken sind Fotolack und/oder Siliziumoxid.

Der in die oberflächennahen Bereiche implantierte Sauerstoff wird dann durch einen Hochtemperaturschritt von beispielsweise 1100°C über einen Zeitraum von zwei Stunden in die gewünschte Tiefe eingetrieben.

Anschließend wird der Wafer mit den fertigzustellenden Leistungshalbleitern über zwei Stunden auf 450°C gehalten, um die thermischen Donatoren zu bilden.

An einem nach dem Verfahren der vorliegenden Erfindung hergestellten Leistungshalbleiter wurde das Dotierungsprofil mittels der Spreading-Resistance-Technik bestimmt. Dabei wurde ein GTO-Bauelement mit kurzgeschlossener Anode verwendet. Das gewonnene Profil entspricht dem in Figur 1 dargestellten. In dieser Figur ist die Dichte der freien Ladungsträger gegen die Tiefe im Substrat aufgetragen. Erkennbar ist der p-Emitter als Bereich einer hohen Ladungsdichte von maximal etwa 10¹⁹ Ladungsträgern/cm³, der auf die Ladungsträgerdichte am p/n-Übergang von etwa 2x10¹² abfällt. Asymptotisch ist rechts die Ladungsträgerkonzentration der Grunddotierung von ca. 8x10¹² zu erkennen. Zwischen diesen Bereichen liegt die erfindungsgemäß hergestellte Stoppzone in einer Tiefe von etwa 15-30 Mikrometern. In ihr steigt die Ladungsträgerdichte auf ca. 4-6x10¹³ an. Diese vergleichsweise hohe Ladungsträgerdichte verhindert, daß sich die Raumladungszone bis tief in den p-Emitter erstrecken kann, stoppt diese also. Damit ist ein Durchgriff bis zum Emitter und der damit einhergehende Verlust der Sperrfähigkeit verhindert.

Elektrische Messungen an nach dem Verfahren der vorliegenden Erfindung hergestellten Leistungshalbleitern zeigen, daß die Sperrspannung um typisch 20-30% bei gleicher Bauelementdicke erhöht ist und daß auch die Abschaltfestigkeit zunimmt, d.h. daß der maximal abschaltbare Strom des Bauelementes erhöht wird. Da die mit der Bildung von Stoppzonen mittels thermischer Donatoren einhergehende Absenkung der Ladungsträger-Lebensdauer im Stoppzonenbereich bei abschaltbaren Bauelementen wie abschaltbaren Thyristoren ein weicheres Schaltverhalten, wie es auch bei anderen Bauelementen mit einer vertikal inhomogenen Trägerlebensdauereinstellung bekannt ist, bewirkt.

## Patentansprüche

1. Verfahren zur Herstellung eines Leistungshalbleiters mit einer Stoppzone, bei dem zur Stoppzonenbildung Sauerstoff in das Substrat gezielt eingetrieben und anschließend mit diesem zur Bildung thermischer Donatoren erwärmt wird, wobei bei oder nahe der Halbleiteroberfläche durch Ionenimplantation eine im Vergleich zu den anderen Halbleiterbereichen erhöhte Sauerstoffkonzentrationen erzeugt wird.

2. Verfahren gemäß dem vorhergehenden Anspruch, bei dem als Ausgangsmaterial für das Halbleitersubstrat Silizium verwendet wird.

3. Verfahren gemäß einem der vorhergehenden Ansprüche, bei dem der Sauerstoff durch Diffusion von dem oder einem, insbesondere oberflächennahen Ort bis zum gewünschten Stoppzonenbereich eingetrieben wird.

4. Verfahren gemäß dem vorhergehenden Anspruch, bei dem das Siliziumsubstrat während des Diffusionsschrittes auf eine Temperatur oberhalb von 520°C und unterhalb von 1200°C erwärmt wird.

5. Verfahren gemäß einem der vorhergehenden Ansprüche, bei dem das Substrat während der Erwärmung zur Bildung thermischer Donatoren auf eine Temperatur zwischen 400°C und 520°C, bevorzugt zwischen 420°C und 500°C, insbesondere bevorzugt 450°C erwärmt wird.

6. Verfahren gemäß einem der vorhergehenden Ansprüche, bei dem der Sauerstoff von einem Bereich aus in das Substrat getrieben wird, welcher p-dotiert ist.

7. Verfahren gemäß dem vorhergehenden Anspruch, bei dem der p-dotierte Bereich, durch welchen der Sauerstoff zu der zu bildenden Stoppzone diffundiert, so hoch p-dotiert wird, daß im Betrieb der Einfluß jener thermisch erzeugten n-Donatoren kompensiert wird, die aus nicht bis zur Stoppzone diffundiertem Sauerstoff hervorgehen.

8. Verfahren gemäß dem vorhergehenden Anspruch, bei dem die Stoppzone in einer Tiefe von 20-40 Mikrometern erzeugt wird.

## Claims

1. Method for fabricating a power semiconductor with a stop zone, in which, in order to form the stop zone, oxygen is driven into the substrate in a targeted manner and subsequently heated with said substrate in order to form thermal donors, in which case, at or near the semiconductor surface, an increased oxygen concentration in comparison with the other semiconductor regions is produced by ion implantation.

2. Method according to the preceding claim, in which silicon is used as a starting material for the semiconductor substrate.

3. Method according to one of the preceding claims, wherein the oxygen is driven in by diffusion from the or a location, in particular near the surface, as far as the desired stop zone region.

4. Method according to the preceding claim, in which the silicon substrate is heated to a temperature of above 520°C and below 1200°C during the diffusion step.

5. Method according to one of the preceding claims, in which the substrate is heated to a temperature of between 400°C and 520°C, preferably between 420°C and 500°C, in particular preferably 450°C, during the heating for the purpose of forming thermal donors.

6. Method according to one of the preceding claims, in which the oxygen is driven into the substrate from a region which is p-doped.

7. Method according to the preceding claim, in which the p-doped region through which the oxygen diffuses to the stop zone to be formed is so highly p-doped that, during operation, the influence of those thermally produced n-type donors which emerge from oxygen that has not diffused as far as the blocking zone is compensated for.

8. Method according to the preceding claim, in which the stop zone is produced at a depth of 20-40 micrometres.

## Revendications

1. Procédé de fabrication d'un semi-conducteur de puissance avec une zone d'arrêt, dans lequel, pour former la zone d'arrêt, de l'acide est introduit de manière adéquate dans le substrat, et est ensuite chauffé avec ce dernier pour former des donneurs thermiques, des concentrations en acide plus élevées que dans les autres régions du semi-conducteur étant produites sur ou à proximité de la surface du semi-conducteur par implantation d'ions.

2. Procédé selon la revendication précédente, dans lequel le matériau de départ utilisé pour le substrat du semi-conducteur est du silicium.

3. Procédé selon l'une quelconque des revendications précédentes, dans lequel l'acide est introduit par diffusion à partir du ou d'un point particulier à proximité de la surface jusqu'à la région de la zone d'arrêt souhaitée.

4. Procédé selon la revendication précédente, dans lequel le substrat de silicium est chauffé pendant l'étape de diffusion à une température supérieure à 520° C mais inférieure à 1 200° C.

5. Procédé selon une des revendications précédentes, dans lequel le substrat de silicium est chauffé pendant l'échauffement pour former des donneurs thermiques à une température comprise entre 400° C et 520° C, de préférence entre 420° C et 500° C, et de préférence encore égale à 450° C.

6. Procédé selon l'une quelconque des revendications précédentes, dans lequel l'acide est introduit dans le substrat à partir d'une région qui est dopée p.

7. Procédé selon la revendication précédente, dans lequel la région dopée p à travers laquelle l'acide se diffuse vers la zone d'arrêt à former est suffisamment dopée pour que soit compensée en fonctionnement l'influence de tout donneur n produit thermiquement qui provient de l'acide non diffusé jusqu'à la zone d'arrêt.

8. Procédé selon la revendication précédente, dans lequel la zone d'arrêt est produite sur une profondeur de 20 à 40 micromètres.
